# EUROPEAN PATENT APPLICATION

(11) **EP 0 642 178 A2**
(43) Date of publication of application: **08.03.1995**
(21) Application number: 94112982.7
(22) Date of filing: 19.08.1994
(51) Int. Cl.: H01L 31/105, H01L 31/115, H01L 25/04

(54) **Semiconductor device for converting light and radiations into electricity**

(30) Priority: 31.08.1993 JP 216571/93; 09.08.1994 JP 187595/94
(71) Applicant: SEIKO INSTRUMENTS INC., Tokyo 136 (JP)
(72) Inventor: Saito, Yutaka, c/o Seiko Instruments, Chiba-shi, Chiba 261 (JP); Sato, Keiji, c/o Seiko Instruments Inc., Chiba-shi, Chiba 261 (JP); Tyo, Teruji, Tsukuba-shi, Ibaragi (JP); Kondo, Mayumi, Tsukuba-shi, Ibaragi (JP); Kohagura, Junko, Tsukuba-shi, Ibaragi (JP)
(74) Representative: Fleuchaus, Leo, Dipl.-Ing.

(57) **Abstract**

A device comprising the first and second detectors arranged to incline at a certain angle and having two-dimentional surface resosution. The device is converting light and radiations into electricity in high energy.

## Description

### BACKGROUND OF THE INVENTION

### (Field of the Invention)

This invention relates to a semiconductor device for converting light and radiations into electricity, such as a PIN diode, an APD diode, a photodiode array, a micro-strip sensor, and so on, in particular to effective structures and applications of a semiconductor device for measuring high energy radiations, e.g. X-rays and γ rays.

### (Discussion of the Related Art)

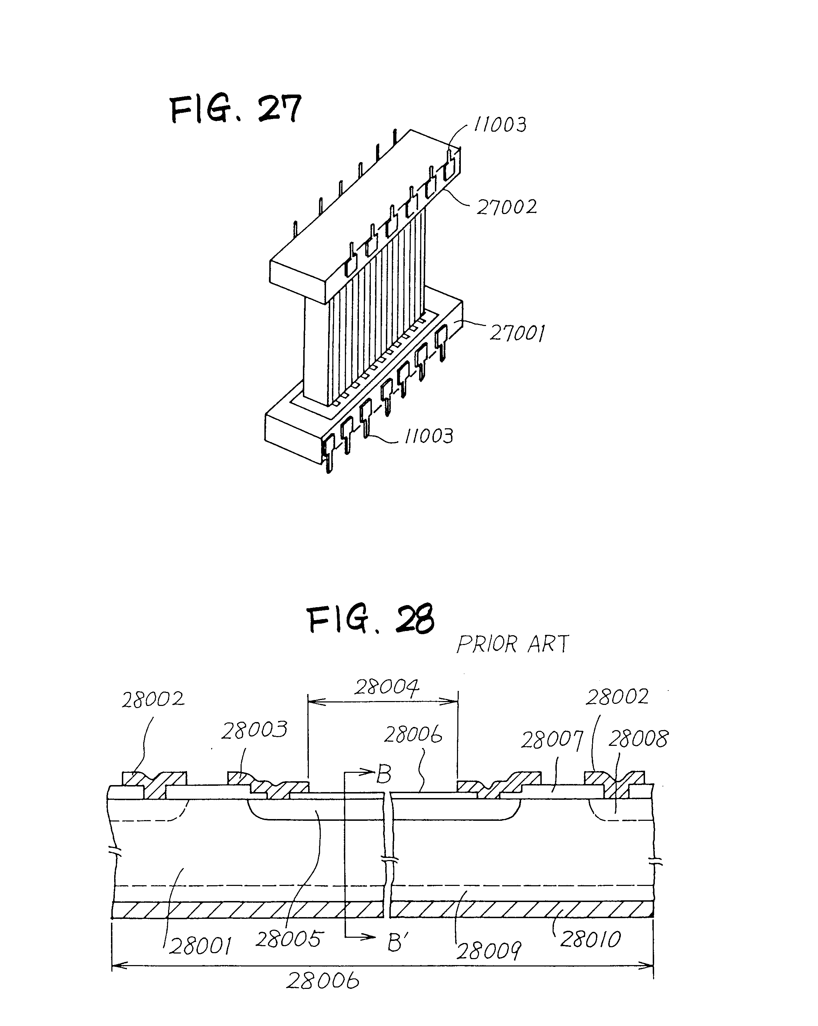

Conventionally, such a detecting device consists of a first conductive type semiconductor substrate, i.e. an N- type-semiconductor substrate 28001, and a second conductive type impurity region, i.e. a P⁺ type impurity region 28005 deposited on the substrate, as shown by Fig.28.

In Fig.28, if the surface having the P⁺ type impurity region 28005 (which is described as P⁺ type layer hereafter) is defined as a front surface of a device, an N⁺ type impurity region (which is described as an N⁺ type layer hereafter) 28009 which has a much higher impurity concentration than the N- type substrate is deposited on a rear surface of the substrate. Hence, the prior device is so called a planar-type PIN diode having a PN junction consisting of P⁺⁻N--N^{+.}

An intrinsic semiconductor includes an impurity concentration of from 1 x 10¹² to 1 x 10¹³ atms/cm³. For example, 1 x 10¹² atms/cm³ is described as "1 E12" by omitting the unit of atms/cm^{3.} The diode is called as PiN or PIN where i or I is originated in i of the word "intrinsic".

An anode 28003 is formed on the P⁺ type layer.

An N⁺ type layer 28008 which becomes a channel stopper is formed on the front surface of the substrate. It is possible to form a cathode 28002 on the N⁺ type layer on the same surface as the P⁺ type layer.

An i layer has a low impurity concentration and a thickness of the i layer is from several dozens to several hundreds of µm. Such a PIN diode has a smaller junction capacitance than other PN diodes because of a big thickness of the depletion layer, when a reverse bias is supplied to the PN junction. The PIN photodiodes are widely utilized due to the high-speed response. This invention will be explained mainly by referring to a PIN diode as an example.

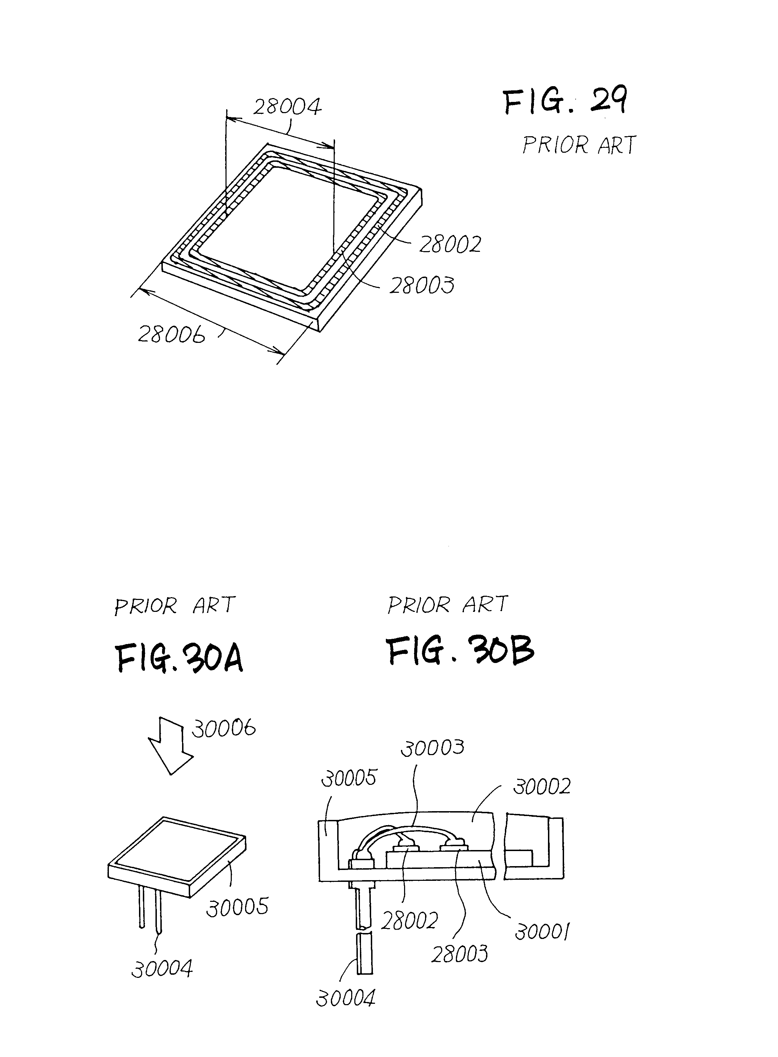

Fig.29 shows a perspective view of a chip of the conventional PIN photodiode. An anode 28003 and a cathode 28002 are arrayed on the chip. The size of the chip, i.e. a side size of the chip, is about from several millimeters to several centimeters. A size of a detecting surface 28004 is a little smaller than the size of chip side 28006.

Fig.30A is a perspective view of a finished product which is called "a mounted photodiode", wherein the prior PIN diode chip is built in a package 30005 in order to provide it with electrodes besides the protection of the chip and an easy treatment of the chip. This is the final structure as a radioactive ray detector or a photodetector. An arrow 30006 denotes the direction of incidence of X-rays, y-rays or light to be measured. The region on which the P⁺ type layer is formed, vertical to the P⁺ type layer, becomes a light receiving surface.

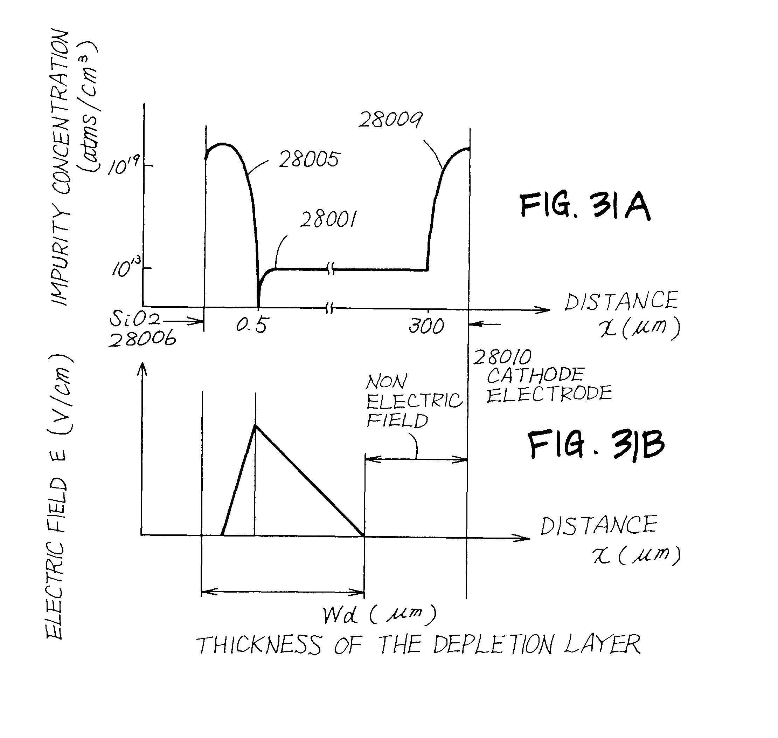

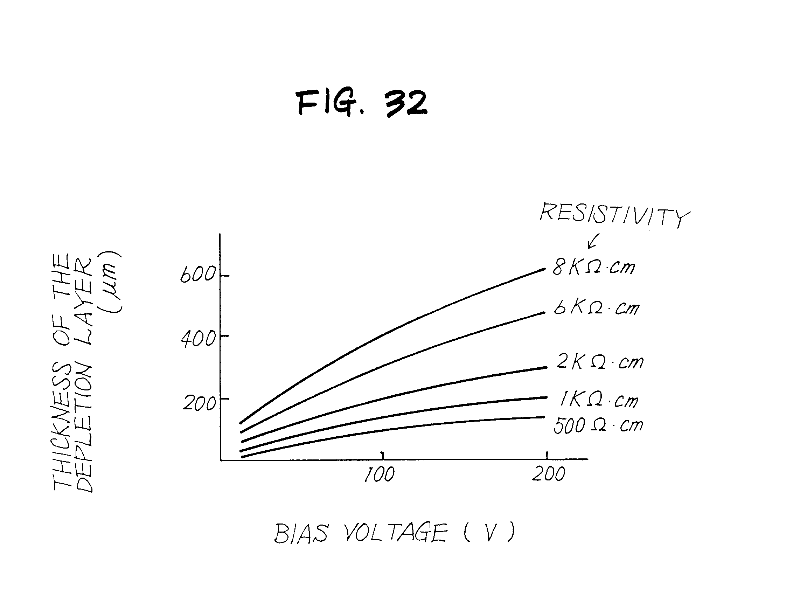

Fig.30B is a cross section view showing that a part of the electrodes of the detector built in is taken out. An anode 28002 and a cathode 28003 are electrically connected to electrode pins respectively with bonding-wires 30003. A resin 30002 is coated for protecting the surface. Fig.31A is a figure showing the impurity concentration distribution of a PIN structure of prior semiconductor device, which is called in short by the named of "impurity profile" hereafter. Hence, the graph shows the impurity profile of the section taken along line B-B' section in Fig.28. At 1Xⱼ = 0.5µm, the impurity concentration has a peak of 2E19. It should be noted that the impurity concentration at the interface between an Si0₂ layer and an Si layer is a little decreased due to the segregation of boron.

Fig.31 B is a figure showing the distribution in the direction of depth of an electric field signifying the depth of the depletion layer (space charge layer) formed on the PN junction when a reverse bias voltage is supplied to the prior semiconductor device. The thickness of the depletion layer W_{d} is a sum of the part forming in the P⁺ type layer and the part formed in the N- type layer. However, since the depletion layer is determined by the concentration of the impurity (resistivity) and the applied reverse bias voltage, the main part of the depletion layer spreads to the N- type layer.

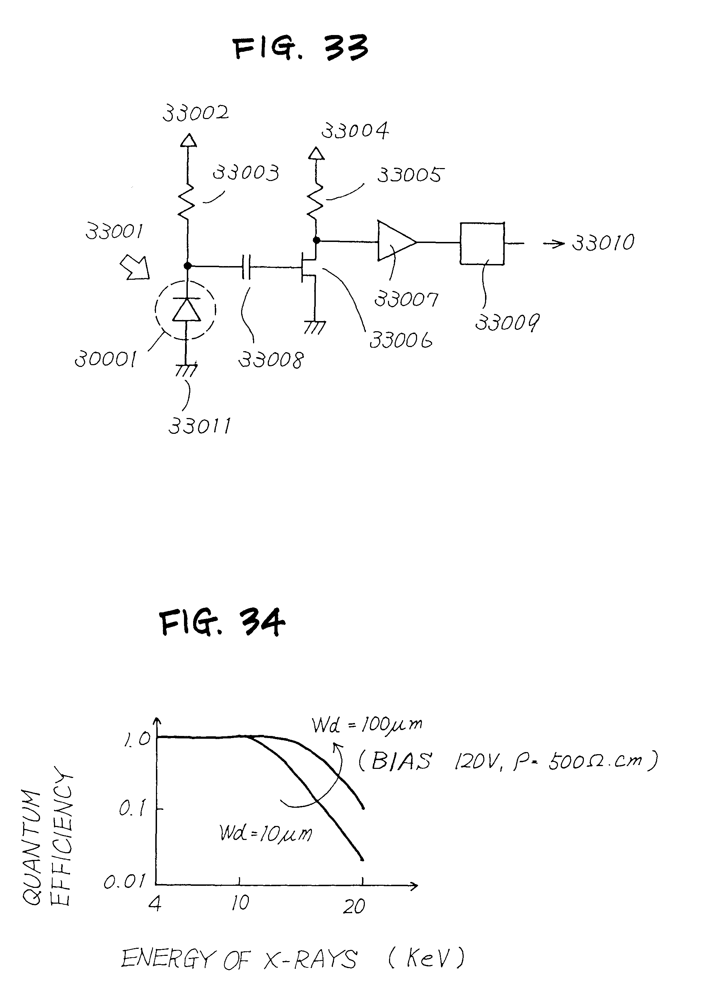

Fig.32 is a graph showing the relation between the reverse bias voltage applied to the PN junction and the thickness of the depletion layer with a parameter of the resistivity of the substrate. 200V of the bias voltage is needed to obtain a 600 µm thickness of a depletion layer at the substrate resistivity of 8 kΩ · cm (which is approximately the limit of Si with extremely high purity)

X-rays and y-rays are electromagnetic waves with high energy, but it is pertinent to consider that these rays are charged particles having a high energy and a high velocity (velocity of light) from the standpoint of the behavior in the semiconductor detector.

When one charged particle passes through the semiconductor device having a band structure, a vast number of electron-hole pairs are made along the path of the particle. These electron-hole pairs are made by two processes, one is to make the electron-hole pairs directly from an incident particle and the other is to make the electron-hole pairs by high-energy electrons which have been made by the incident particle. What is important is that the mean energy of the primary charged particle spent for making a pair of electron-hole pair when the semiconductor device is used as a detector, in spite of the complicated mechanism. The mean energy is often called "ionization energy", which scarcely depends on the sorts or the energy of incident light or radiations.

Therefore, it is possible to convert the energy of the particle into the number of electron-hole pairs when a particle completely stops at the sensitive region of the detector (namely the depletion layer). How deep the depletion layer can be spread determines how much the high energy is detected.

Fig.33 is a circuit figure showing a typical circuit of a ordinary light or radiations. In the circuit, a detector 30001 (a PIN diode) is connected to a power source HV33002 through a bias resistor (ordinarily a resistor more than 1 Mg is used for obtaining a high input impedance). When radiations, e.g. X-rays enter the detector, a corresponding current flows. The current passes through the bias resistor 33003. The voltage change is transferred through the capacitance 33008 to a gate of a JFET33006 which substantially converts the impedance of the signal. The signal is amplified by an amplifier 33007. Then the signal is reformed in a regular wave form by a wave reform circuit 33009. Then the signal is introduced to a MCA33010 (Multi Channel Analyzer: a device for spectroscopic analysis) for a signal processing. The drain of JFET is connected via a resistor 33005 for a constant current to a power source of a Vcc33004 of 5V.

Fig.34 is a graph showing the relation between the quantum efficiency and the energy of X-rays, wherein a depletion layer with a 100 µm thickness and a depletion layer with a 10 µm thickness are cited as a parameter. As read from the graph, the quantum efficiency of the detector even with a 100 µm thick depletion layer drops to one tenth at 20 keV of X-rays. Hence, spectroscopic analysis with energy resolution is impossible. Therefore, X-rays more than 100 keV or y-rays up to 1 MeV are converted to light and the light power is detected by a scintillator. An Si-Li detector and a high impurity Ge (Germanium) detector are also used therefor.

The Si-Li detector comprises a P- type Si with Li, till the Si approaches to an intrinsic semiconductor as thoroughly as possible. The depletion layer attains several millimeter of thickness at a reverse bias of hundreds of volts in the Si-Li detector. The Ge-detector can obtain a 1 cm-thickness of depletion layer at a reverse bias of several hundreds of V, because making a highly pure Ge crystal is easier than Si. However, these detectors are far inferior to the planar type of PIN diode above-explained in the strong dependence on temperature, in the necessity of maintaining the devices at a low temperature, and in the large leak which causes noise, and gives a bad influence to the S/N ratio.

On the other hand, the devices combining a scintillator crystal, e.g. Ti-doped Nal, Csl, CdW0₄ or Bi₄Ge₂0,₂ with a photomultiplier or with a conventional PIN diode are suggested, but it is difficult to obtain a small sized combination with a high sensitivity.

On the other hand, the case of light will be explained. The incident light to a device interferes with a Si atom, and emits the energy corresponding to hv to create electron-hoe pairs due to the photoelectric effect, and electron-hole pairs are detected as a current by a detector. Only the incident light captured in the depletion layer contributes to a signal. In the photoelectric effect, however, there is a threshold wavelength which is determined by the bandgap. In the case of Si, there is hardly any quantum efficiency left for the light longer than a 1.2 µm wavelength, because the energy of a photon is lower than 1.1 eV which is a bandgap of Si. Further, when the high energy light of a wavelength shorter than 500 nm is introduced from the side of P⁺ type layer, the attenuation due to the absorption of P+' type layer is large. Further, the thicknesses of insensitive layers, e.g. P⁺ type layer 28005, Si0₂ layer 28006 cause serious problems.

The charged particles with a low velocity, e.g. a-rays, has the similar problem to light

As mentioned about the conventional semiconductor devices, there are many problems to be solved therein.

First of all, it is difficult to make the depletion layer with a thickness more than several millimeter is made. Therefore, it is necessary to combine a PIN detector with a scintillator crystal.

An extent large voltage, e.g. 100000 V would be necessary to form a depletion layer with several mm of thickness, even though a Si crystal with the highest purity, e.g. 1 E12 were used. This is not practical. Even if it were to be realized, the leak current would become extremely large.

### SUMMARY OF THE INVENTION

This invention employs the following means.

As a first means, a plurality of planar type PIN diodes are heaped in this device.

In this case, it is preferable that the thickness of the connecting interface between the neighboring PIN diodes should be less than 20 % of the thickness of a PIN diode. Further, light should be introduced in the direction not vertical to but parallel with the surfaces of the diodes.

As a second means, the resistivity of the P- or N- substrate (a lower concentration side of PN junction in both N- type and P- type, the side the depletion layer is mainly spread) should be more than 1 k^{g -} cm. Considering the relation between the thickness of the substrate and the resistivity, the resistivity more than 1 kΩ · cm is effective, when the thickness of the substrate is less than 300 µm. When the thickness of the substrate is less than 500 µm, the resistivity should be more than 4kΩ · cm. When the thickness of the substrate is less than 1 mm, the resistivity should be more than 8 k^{g} - cm. When the thickness of the substrate is less than 2mm, the resistivity is preferably more than 20kΩ · cm. Further, it is practical that the depletion layer is expanded to at least 60 % of the thickness of substrate by an application of the reverse bias.

As a third means, the multiplied PIN diodes ace electrically connected in parallel series.

As a fourth means, two PIN diodes are connected with the substrate face to face. The equivalent electrodes of two PIN diodes are connected to each other with a conductive adhesive. As a fifth means, the piled PIN diodes are provided with electric terminal parts alternatively on opposite sides vertical to the incident direction of light.

As a sixth means, a plurality of the multiplied PIN diodes are assembled by changing an angle therebetween.

As a seventh means, the piled PIN diodes have bias resistors connected to anodes and junction capacitors connected to the anodes on the same semiconductor substrate. (in the case of N_{1T}P, a bias resistor and a junction capacitor should be connected to cathodes)

As a eighth means, the multiplied PIN diodes are produced by piling a lot of PIN diodes where P⁺ type impurity region is divided into pieces like strips of paper.

As a ninth means, when the piled PIN diodes are utilized as a detector for radiations, radiations is directly introduced into the PIN diode without passing through a scintillator crystal.

As a tenth means, the laminated PIN diode of this invention is utilized as a detector of an X-ray CT device.

Functions of this invention will be explained.

Owing to the first means, it is possible that the thickness W_{d} of the depletion layer is spread to a size similar to a side size of a device. Therefore, it is possible to widen the thickness of the depletion layer to several tens of cm, according to the energy of radiations to be measured. (for example, it is possible to spread to an effective diameter of a wafer in the case of an Si wafer process) Further, there are many advantages, e.g. a planar type PIN diode can be used as a device, and a bias voltage for obtaining a depletion layer is only several tens of V. Hence, it is possible to detect X-rays with more than 100 keV of energy or y-rays with more than 1 MeV of energy by a Si planar type PIN diode. Further, since the insensitive layers can be excluded as thoroughly as possible, an efficient detection can be achieved for a-rays or the light with a wavelength of less than 300 nm. Furthermore, since a W_{d} of more than 1 cm can be made, a good sensitivity is obtained for the light with a wavelength of more than 2 µm which is a threshold wavelength of Si to light.

Owing to the second means, a good quantum efficiency can be realized. Further, the leak current can be sufficiently decreased, because the depletion layer is not spread on the whole surface of the substrate.

Owing to the third means, since bias voltage is independently applied to individual devices, it is unnecessary to provide a power source with a high voltage of more than several hundreds of V. Further, since a bias voltage is divided into individual devices, the depletion layer has the same thickness, even if the resistivity of each device is fluctuated.

Owing to the fourth means, the structure of an outer electric terminal becomes simple.

Owing to the fifth means, the wiring to outer terminals becomes simple.

Owing to the sixth means, it is possible to realize the radiation-ray spectroscopic analysis in two-dimensional space with high resolution.

Owing to the seventh means, the structure of circuits becomes simple.

Owing to the eighth means, it is possible to realize the radiation-ray spectroscopic analysis in two-dimensional space with high resolution. two-dimensional information or space.

Owing to the ninth means, a detector for detecting radiations with a high sensitivity and a high resolution enjoys a simple structure

Owing to the tenth means, an X-ray CT device with a high speed and a high resolution can be obtained.

### BRIEF DESCRIPTION OF THE DRAWINGS

Fig.1 is a sectional view of a PIN diode of this invention;
Fig.2 is a perspective view of a PIN diode of this invention;
Fig.3 is a circuit figure of a semiconductor device of this invention;
Fig.4A is a perspective view of a semiconductor device mounted in a armoring case; Fig.4B is a sectional view of Fig.4A;
Fig.5 is a graph showing the relation between the quantum efficiency and the energy of radiations by taking several detectors as parameters;
Fig.6 is a circuit figure used for detecting radiations;
Fig.7A is a graph showing the distribution of the impurity concentration of the detecting device of this invention; Fig7B is a graph showing the relation between the electric field intensity and the thickness of the depletion layer by taking prior device and the present device as parameters;
Fig.8 is a graph showing the relation between the quantum efficiency and the energy of X-rays at 200 µm in thickness of the depletion layer;
Fig.9 is a graph showing the relation between the quantum efficiency and the wavelength of light by taking an Si PIN detector of this invention and prior Si PIN as parameters;
Fig.10 is a circuit of a detecting device of this invention;
Fig.11A is a perspective view of a detecting device of this invention; Fig.11 B is an enlarged view of part [a] in figure Fig.11A;
Fig.12 is a perspective view of a detecting device of this invention.
Fig.13A is a perspective view of a detecting device of this invention; Fig.13B is an enlarged view of part [b] in figure Fig.13A;
Fig.14 is a circuit figure showing a detecting device of this invention;
Fig.15 is a sectional view of a PIN diode of this invention;
Fig.16 is a perspective view of a detecting device of this invention;
Fig.17 is a perspective view of a detecting device of this invention;
Fig.18A is a perspective view of a detecting device of this invention; Fig.18B is a sectional view of a detecting device of this invention;
Fig.19A is a circuit figure showing a first example of the connection of fourth embodiment;
Fig.19B is a second example of the connection of fourth embodiment;
Fig.20 is a perspective view of a detecting device of this invention;
Fig.21 is a perspective view of a detecting device of this invention;
Fig.22A is a sectional view of a detecting device of this invention; Fig.22B is a sectional view of a detecting device having the same axis of this invention;
Fig.23 is a sectional view of a detecting device of this invention;
Fig.24 is a perspective view of a detecting device of this invention;
Fig.25 is a circuit figure of a detecting device of this invention;
Fig.26 is a circuit figure of a detecting device of this invention;
Fig.27 is a perspective view of a detecting device of this invention;
Fig.28 is a sectional view of prior detecting device;
Fig.29 is a perspective view of prior PIN diode;
Fig.30A is a perspective view of prior PIN diode;
Fig.30B is a sectional view of a part for taking out an electrode in prior PIN diode;
Fig.31A is a graph showing the distribution of impurity concentration of prior detecting device;
Fig.31 B is a graph showing the relation between the electric field intensity and the thickness of the depletion layer of prior device;
Fig.32 is a graph showing the relation between the thickness of the depletion layer and the bias voltage;
Fig.33 is a circuit figure of an ordinary detecting device;
Fig.34 is a graph showing the relation between the quantum efficiency and the energy of X-rays;
Fig.35 is a plan view of a detecting device wherein a P⁺ type layer is divided into pieces;
Fig.36 is a perspective view of a detecting device of ninth embodiment of this invention, wherein a P⁺ type layer is divided into pieces;
Fig.37 is a diagram of a detecting device of this invention;
Fig.38 is a conceptional view of an X-ray CT device of this invention;
Fig.39 is a sectional view of a device for converting light and radiations into electricity of this invention;
Fig.40 is a circuit figure of a detecting device of this invention;
Fig.41 is a circuit figure of a detecting device of this invention;
Fig.42 is a circuit figure of an example of a semiconductor substrate, wherein a P⁺ type layer is divided into pieces;
Fig.43 is a conceptional view of an X-ray CT device of this invention;
Fig.44 is a another conceptional view of an X-ray CT device of this invention;
Fig.45 is a plan view of a semiconductor device of this invention;
Fig.46 is a sectional view of a semiconductor device of this invention;
Fig.47A is a side view of a mounting example of a semiconductor device of this invention;
Fig.47B is a plan view of same;
Fig.48 is a plan view of a semiconductor device of this invention; and
Fig.49 is a sectional view of a mounting example of a device for converting light and radiations into electricity, wherein a P- type layer is divided into pieces.

### DETAILED DESCRIPTION OF THE PREFFERED EMBODIMENTS

Embodiments of this invention with the best mode will be explained by referring to the accompanying drawings wherein.

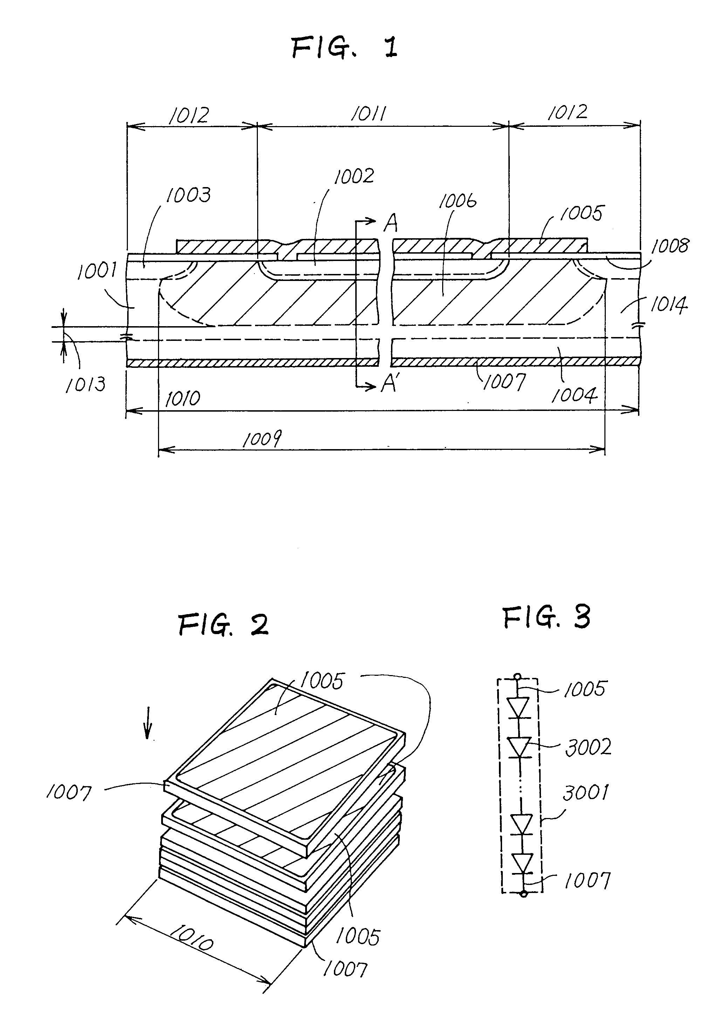

Fig.1 is a sectional view of a PIN diode device (one chip) of a first embodiment of this invention. As shown by Fig.1, the PIN diode device has an N- type semiconductor substrate 1001 as a first conductive type semiconductor substrate, and a P⁺ type impurity region 1002 as a second conductive type semiconductor impurity region. As known from Fig.1, the P⁺ type impurity region 1002 is deposited on a front surface of the substrate, and an N⁺ type impurity region 1004 is deposited on a reverse surface of the substrate. Hence a PN junction consisting of P⁺⁻N--N⁺ is formed thereon. Such a device is so called "planar type PIN diode". Such a diode having such a PIN structure will be explained as an example. A diode having an NnP structure is similarly available as an example of this invention, and is applicable according to necessities. For example, aπl ayer, i.e. a P- type layer with a high resistivity can accomplish a high gain due to the high mobility of minority carriers, but has the problem of reproductivity.

The substrate is an N- type layer (substrate) with an impurity concentration of from 4E12 to 1E11.

A P⁺ type layer has an impurity concentration of from about 1 E19 to 1 E21, and a diffusion depth Xⱼ of from about 0.1 to 2.0 µm. Here Xⱼ is a vertical distance from the surface to a PN junction. An N⁺ type layer 1004 has an impurity concentration of from about 1 E19 to 1 E21, and a diffusion layer with a depth Xⱼ of from about 0.5 to 2.0 /1.m.

A cathode 1007 is disposed on the reverse surface to the P⁺ type layer 1003. A surrounding part of the P⁺ type layer is covered with the N⁺ type layer 1003 as a channel stopper.

In Fig. 1, the side 1011 of the P⁺ type layer and the distance 1012 between the end of the P⁺ type layer and the end of the device 1012 are shown.

Fig.2 is a perspective view showing the state depositing devices of the first embodiment of this invention. As shown by Fig.2, a cathode of a chip is connected to an anode 1005 of a next chip. In this connection, it is possible to use a conductive adhesive or a pressing fixation by a package.

Fig.3 is a circuit figure showing an electric connection of the disposed devices of the first embodiment of this invention. N numbers of diodes are connected in series to a device.

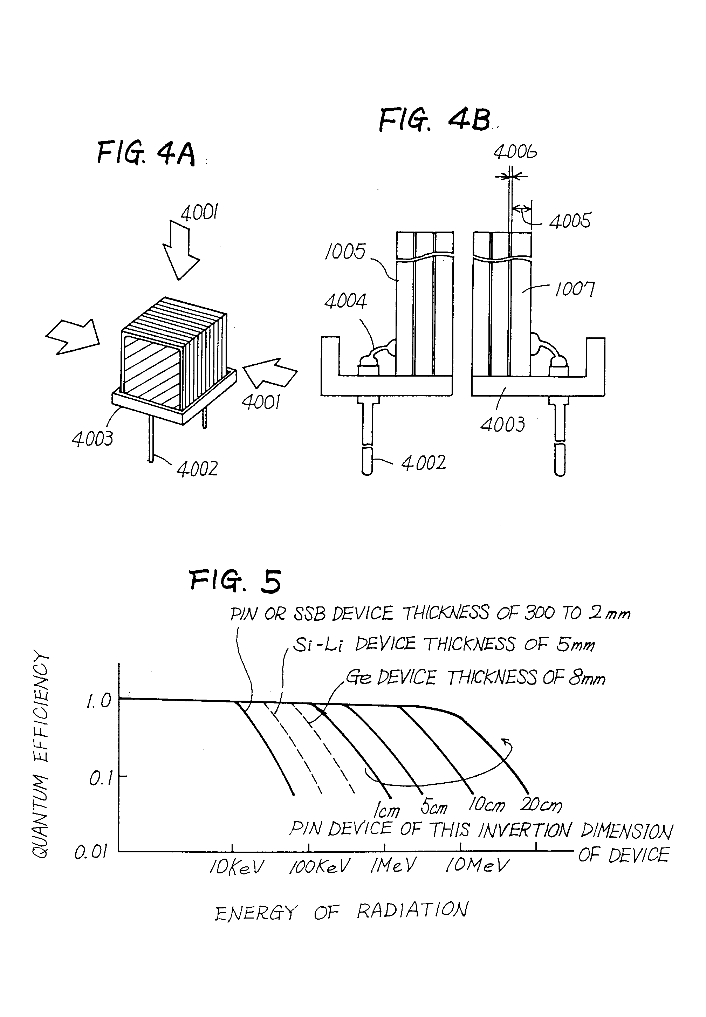

Fig.4A is a perspective view of a finished detector for radiations, wherein a package 4003 is installed in order to provide electrodes of the device.

This package 4003 has electrode pins 4002. Arrows 4001 show incident directions of X-rays or y-rays. In the conventional detector, X-rays or so on is used to be introduced in a direction vertical to a surface of a PIN diode chip. In this device, however, X-rays or so on enter a side in parallel with the surfaces of the piled devices. Hence, the thickness Wⱼ of the depletion layer is approximately equal to the side 1010 of the chip, as shown by Fig.1. It is, however, not good for the depletion layer to spread in the direction of depth in the substrate as deep as possible.

Because the spread of depletion layer over the limit results in the breakdown of diode and the increase of the leak current bringing about a bad S/N ratio.

As a result, the region 1013 without the depletion layer exists in the substrate. The existence of the non-depletion layers incurs a question about the spectroscopic analysis of detection.

Fig.4B is a sectional view of a finished detector for radiations, wherein a package 4003 is installed in order to provide the electrodes of the device with connections. In Fig.4B, a thickness 4005 of the substrate is shown. The anode pad 1005 and the cathode pad are connected to the electrode pins with a bonding wires 4004. It is preferable that the thickness 4006 of the interface is as thin as possible. However, an adhesives, conductive films, or insulating films, e.g. Maira, Capton which are product names, is included in the interface. According to the Inventor's researches, a sufficient quantum efficiency can be obtained, even if the thickness of the interface is 20 % of the thickness of a PIN diode device. For example, if the thickness of a PIN diode is 300 µm, the interface thickness should be reduced to less than 60 µm.

Fig.5 is a graph showing the relation between the quantum efficiency and the energy of radiations wherein parameters are three kinds of detectors.

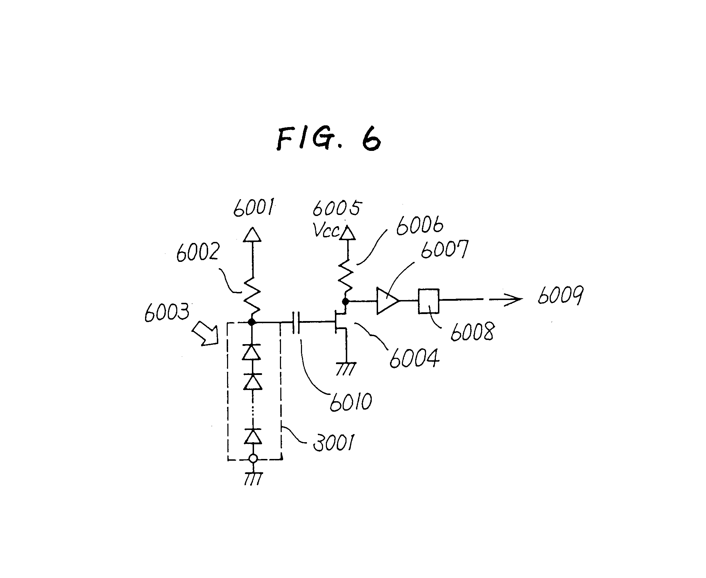

Fig.6 is a circuit figure used for the detector of detecting radiations of the embodiment of this invention. The detector 3001 is connected to a bias power source HV6001 via a bias resistor 6002. When y-rays with energy of from 2 keV to 100 MeV are radiated to the detector, a current flows in proportion to the energy. The current passes through the resistor 6002, where the voltage change is transferred through the capacitance 6010 to a gate of a JFET6004 which converts the impedance of the signal. The signal is amplified by an amplifier 6007. Then the signal is reformed in a regular wave form by a wave reform circuit 6009. Then the signal is introduced to a MCA6009 (Multi Channel Analyzer: a device for spectroscopic analysis) for a signal processing. The drain of JFET6004 is connected via a resistor 6006 for constant current to a power source of a Vcc6005 of 5V. The structures of the detectors of this invention will be explained hereafter, but the fundamental composition of the electric circuits is nearly similar to the above mentioned circuit.

As known from Fig.5, an effective detecting range of the conventional PIN or SSB (surface barrier type detector) is nearly several tens of keV, e.g. X-rays with an energy of about several tens of keV, that of SI-Li type is approximately 100 keV, and that of Ge type is nearly 1 MeV, e.g. y-rays with an energy of about 100 MeV. On the other hand, Si PIN detectors have large effective ranges, as shown by Fig.5, because formed depletion layers are spread as deep as possible in order to obtain a sufficient quantum efficiency. However, the insensitive region 1013 without a depletion layer would be a serious barrier to achieve the spectroscopic analysis. As long as the insensitive layer exist, it seems impossible to proceed in the spectroscopic analysis. The inventors, however, have contrived a device which can solve this problem. In the next state, their study will be explained in detail.

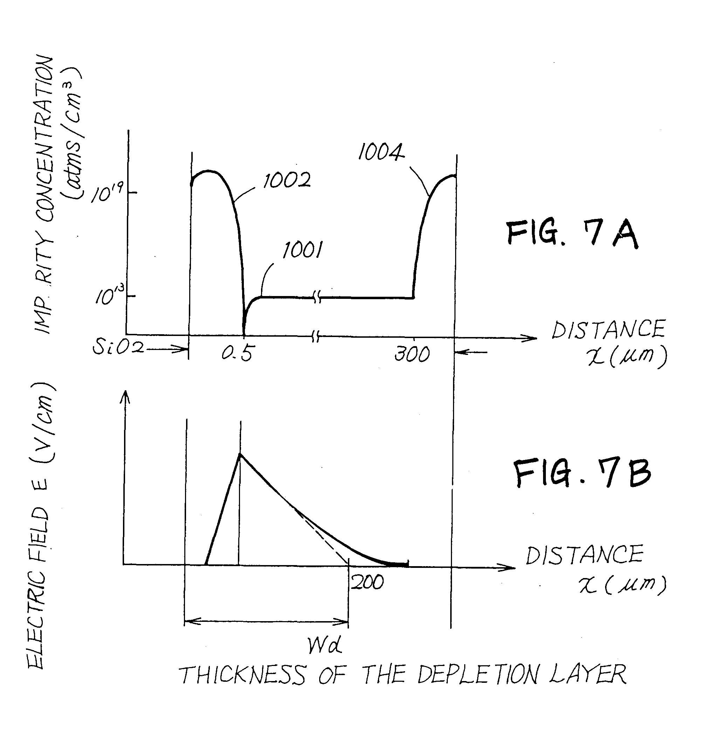

Fig.7A is a graph showing a distribution of impurity concentration (which is described as impurity profile hereafter) of the PIN structure of the detector of this invention. Hence, Fig.7A shows an impurity profile taken along A-A line in Fig.1. Fig.7B is a graph showing a distribution of the electric field corresponding to the depletion layer spreading on the PN junction in x-direction, when a bias voltage in a reverse direction is applied to the conventional device. The thickness W_{d} of the depletion layer is a sum of the length spreading in P⁺ type layer and the length spreading in N- type layer. Since the depletion layer is mainly influenced by the impurity concentration (resistivity), the main part is spread to the N- type layer. Of course, the reverse bias voltage applied is one of factors.

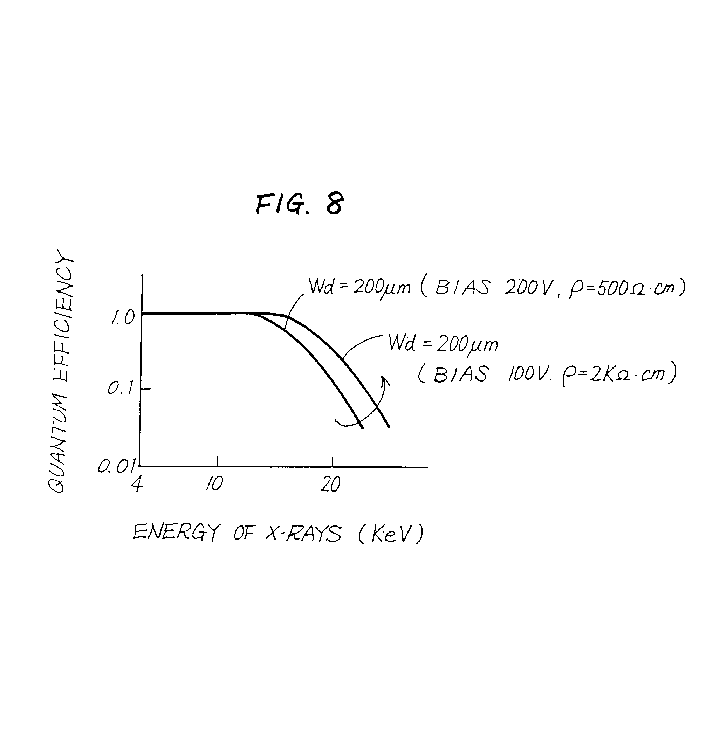

Fig.8 is a graph showing the relation between the quantum efficiency and the energy of X-rays, wherein the thickness W_{d} of the depletion layer is commonly determined to be 200 µm by adjusting the applied bias, and the resistivity is changed as a parameter. As known from Fig.8, even if the thickness W_{d} of the depletion layer is defined to be the same value , e.g. 200 µm, the quantum efficiency for the resistivity of 2 k^{g -} cm is higher than the quantum efficiency when the resistivity is 500Ω· cm. There is little difference when the resistivity becomes less than 500Ω· cm. In Fig.7B, the distribution of the electric field is not a straight line (based on the conventional theory and shown with a dotted line) but a slow curve, which means the depletion layer is slightly spreading to the N⁺ type layer.

According to the Inventors' researches, such a tendency of the extension of the depletion layer into N⁺ type layer appears when the depletion layer spreads to more than 60% of the thickness of the substrate. When the thicknesses of the substrate is less than 300 µm, less than 500 µm, less than 1 mm, and less than 2 mm, the resistivities shall be more than 1 kΩ· cm, more than 4 k^{g} - cm, more than 8 kΩ· cm, and more than 20 kΩ· cm, respectively for the extension. Therefore, it is possible to spectroscopically detect the radiations with high energy, because the insensitive field region, i.e. non-electric field region which is an obstacle for detecting rays with high energy is eliminated by adjusting the resistivity of the substrate, the thickness of substrate, and the bias voltage.

This is an extremely innovative invention, because this device can displace the Si-Li type detector, Ge-type detector and the PIN detecting devices with scintillator.

Next, the case of detecting light will be explained.

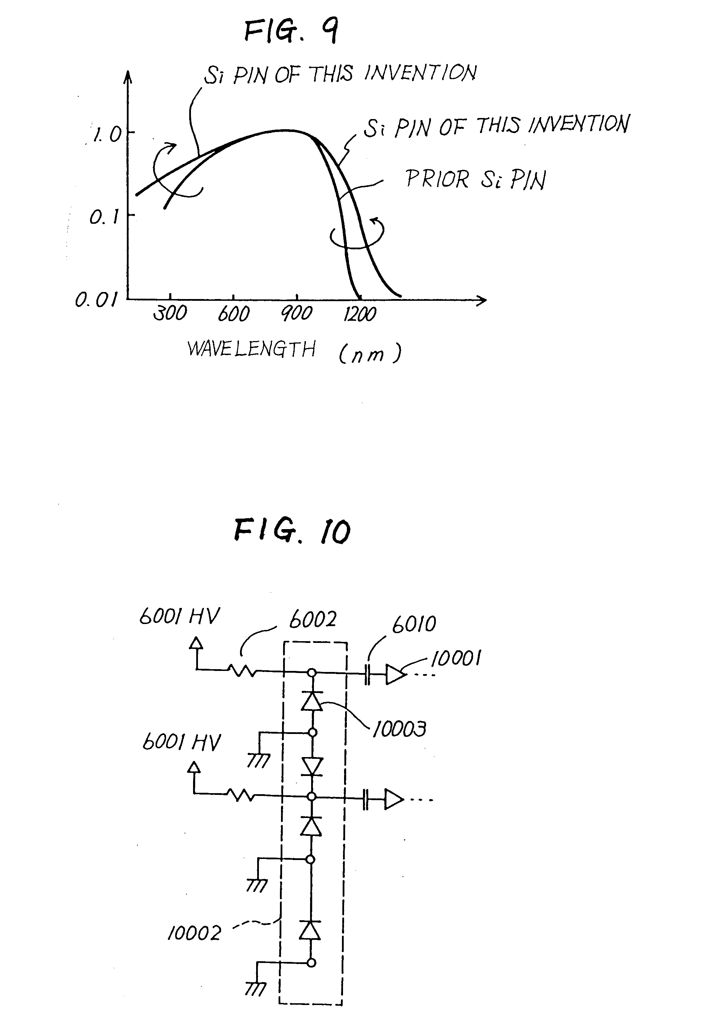

Fig.9 is a graph showing the relation between the quantum efficiency and the wavelength by citing two kinds of detectors as parameters. As known from Fig.9, this Si PIN detector has higher quantum efficiency than prior Si PIN detectors in the longer range of more than 1.2 µm and in the shorter range of less than 300 nm. When the photoelectric effect in the long wavelength region, e.g. more than 1200 nm is considered, there is a threshold wavelength which is determined by the band gap. In the case of Si, there would be hardly any quantum efficiency left. However, it is possible to detect such light with a long wavelength by making a side of a chip more than 1 cm in this invention.

It is assumed that an incident photon can be finally detected as an electric signal converted from lattice vibrations or heat which are generated by the interference between Si atoms and the incident photon while the incident photon is passing through the Si crystal.

When the photoelectric effect in the short wavelength range is considered, the reason is simple. Although prior PIN diodes have insensitive layers, e.g. P⁺ type layer and Si0₂ layer which are not sensitive to the incidence of light, the present detector possesses no insensitive layer. As known from Fig.1, it is possible to spread the depletion layer to the vicinity of the end surface 1014 by setting the distance between the end of P⁺ type layer and the end of the chip, a thickness of substrate, a resistivity of substrate, or a bias voltage Further, the above-mentioned detection in the non electric field region is likely to give a contribution.

Fig.10 is a circuit figure showing an electric connection of a second embodiment of the detecting device utilizing this invention. In this detecting device 10002, every device are electrically connected with each other not in series. As shown in Fig.10, the anodes of two devices are connected with each other, and a common terminal is provided. On the other hand, the cathode is connected to a cathode of the next device, and a common terminal is also provided. A necessary bias voltage to be applied corresponds to the value enough to spread a single depletion layer to a predetermined distance. Therefore, the bias voltage is reduced in comparison with the connection in series (in this case, necessary bias voltage would be a sum of numbers of deposited devices). The detecting circuits after a junction capacitors 6010 are connected to terminals from each cathode, whereby this device becomes a line-sensor with one-dimensional resolution.

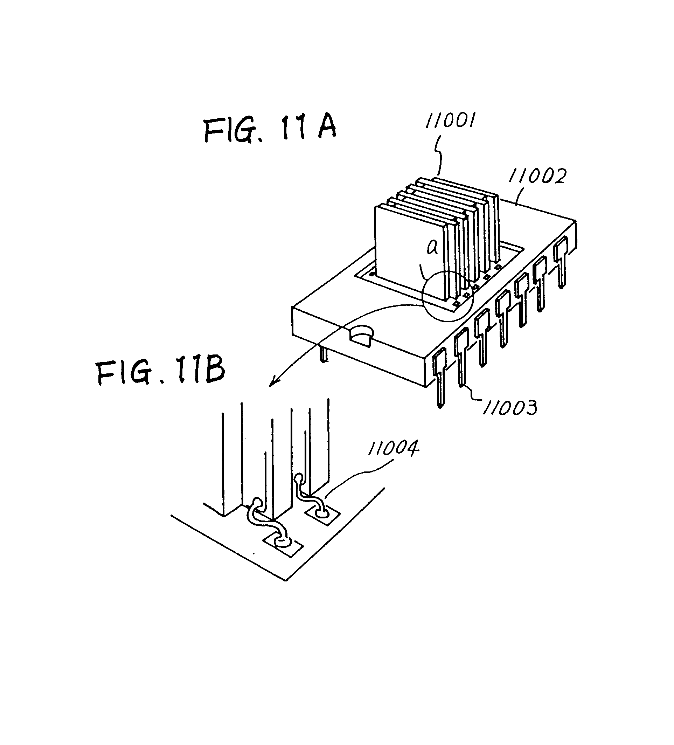

Fig.11A is a perspective view of a detecting device of the second embodiment, wherein a first example of mounting the present detecting device is shown. This detecting device is mounted in a DIP package having electrode pins 11003. It is convenient to utilize a package, e.g. a DIP (Dual In line Pin) package 11002 for semiconductor integration circuits because of polyterminal output power. Fig.11 B is an enlarged figure of part (a). Electric terminal parts from multiplied devices are alternatingly protruded, whereby each anode terminal and each cathode terminal are electrically connected to electrode pins with wirebondings. The opposite side not shown in Fig.11 B has also the same structure.

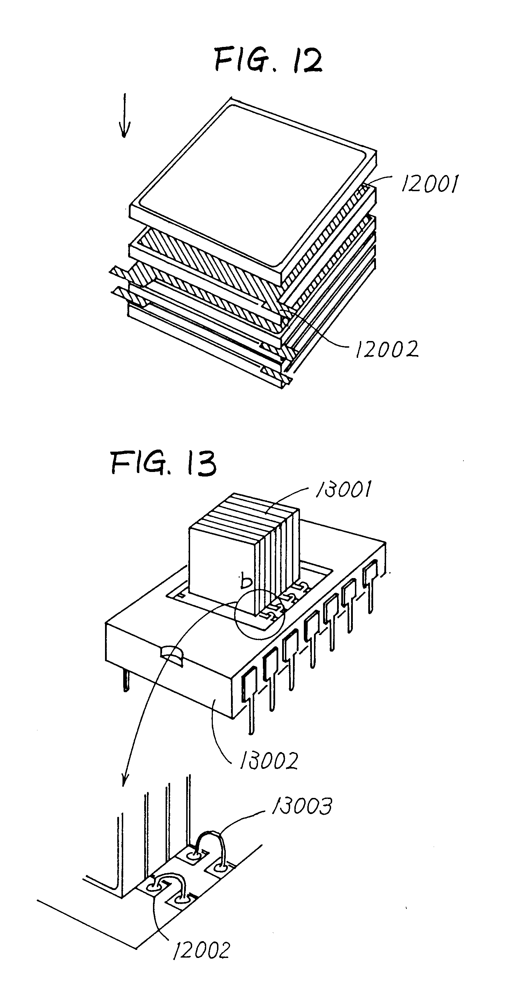

Fig.12 is a perspective view of a detecting device of the second embodiment, wherein a second example of mounting the present detecting device is shown. Conductive films 12001 are inserted into between devices. These conductive films 12001 have tags which are protruded like tails.

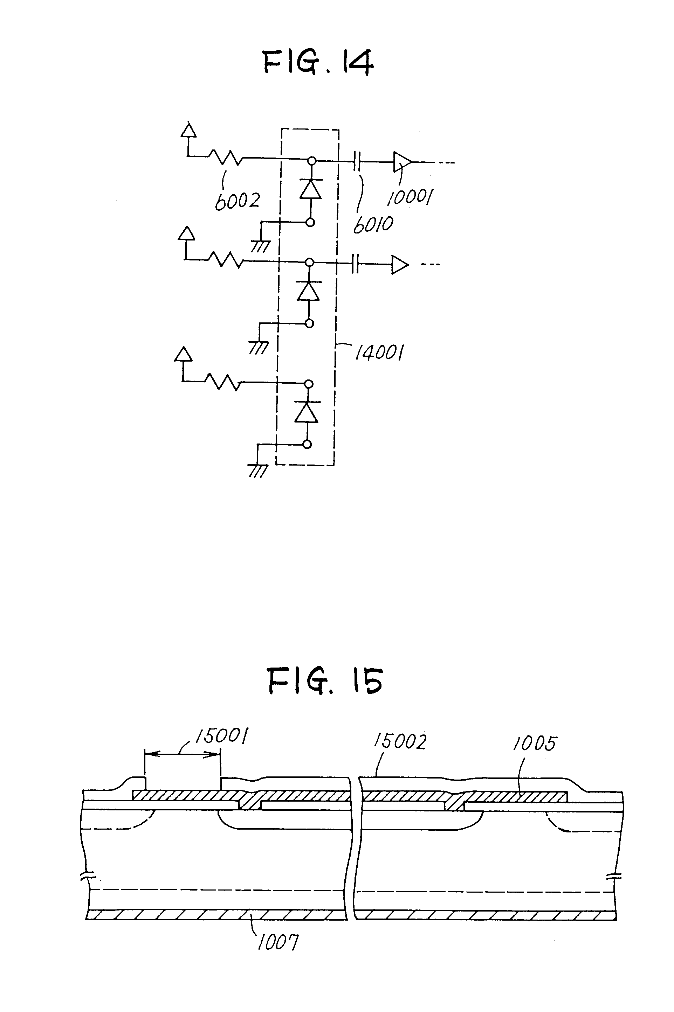

Fig.13A is a perspective view of a detecting device 13001 of the second embodiment, wherein a second example of mounting the present detecting device is shown. It is convenient to utilize a package, e.g. a DIP (Dual In line Pin) package 13002 for semiconductor integration circuits because of polyterminal output power. Fig.13B is an enlarged figure of part (b). Wirebondings 13003 is possible by using out-protruded tag parts 12002. Hence, each device can be multiplied without disposing alternating with each other. Fig. 14 is a circuit figure showing the electric connection of the detecting device 14001 of the third embodiment of this invention. Each device has an independent anode and an independent cathode. An output signal is output from a amplifier 10001. A proper depletion layer is controlled by each device, because a bias voltage can be independently controlled).

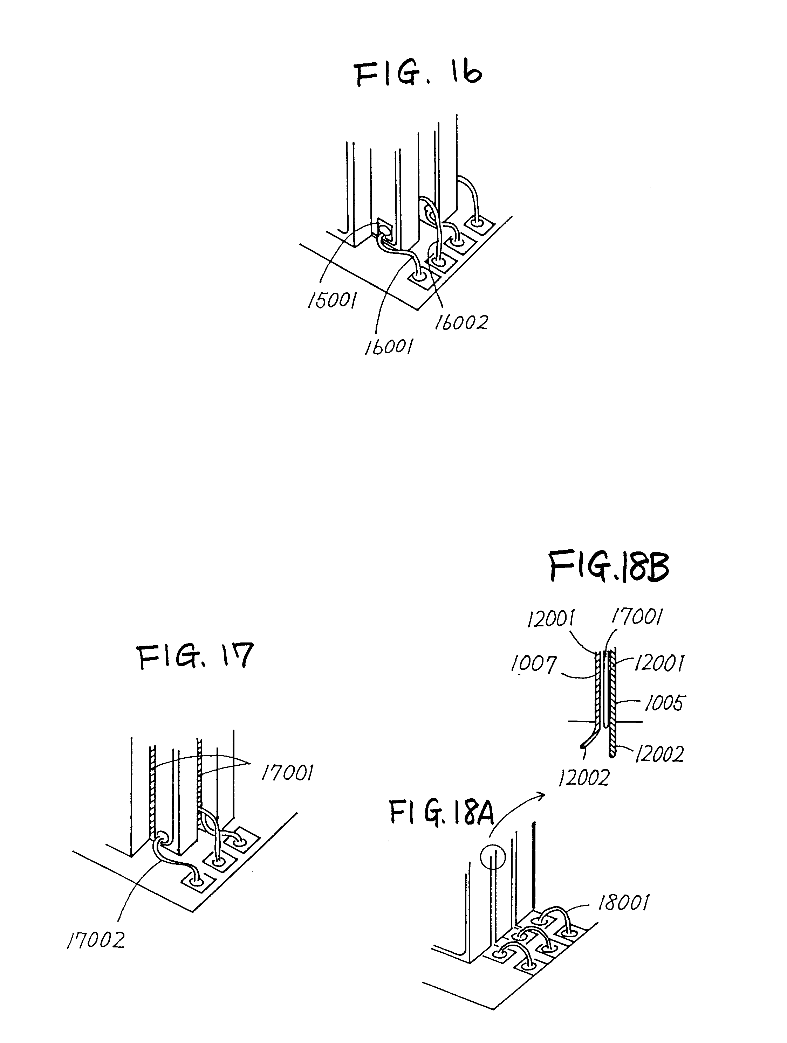

Fig.15 is a sectional view of a single PIN diode (one chip or one substrate) which is used in a first mounting example of the third embodiment. A passivation layer 15002, e.g. an SiN layer is deposited on an anode 1005 for electric insulation. An opening part 15001 is formed on an end of the anode . A cathode 1007 is disposed on an opposite side of the anode electrode. Fig.16 is a perspective view showing a detecting device of the first mounting example of the third embodiment. Unit devices alternatingly deposited are covered with the passivation layer for insulating. Each anode is connected to a lead pin via an opening part 15001 with a bonding wire 16001. Each cathode is also connected to another lead pin with a bonding wire 16002.

Fig.17 is a perspective view showing the detecting device of the second mounting example of the third embodiment. An insulating film 17001 is inserted between devices instead of the passivation layer. An electrode is connected to a lead pin with a bondingwire 17002. Fig.18A is a perspective view showing a detecting device of the third mounting example of the third embodiment. This detecting device is similar to the device of the second mounting example of the second embodiment. A conductive film with a tag is inserted between devices. It is possible to align sides of unit devices on the same plane due to the tags. Fig.18B is a sectional view showing the film inserted between the detecting devices of the third mounting example of the third embodiment. The tag 12002 is protruded from the conductive film 12001. Since an insulating film 17001 is inserted between devices, an anode 1005 and a cathode 1007 are insulated thereby.

Detailed explanation of this invention has been done. Since there need a lot of terminals for outputting and a high skill for bonding extended over both surfaces, i.e. a rear surface and a front surface in the third embodiment. Therefore, it is convenient to provide a packages 27001 and 27002 having electrode pins, as shown by Fig.27.

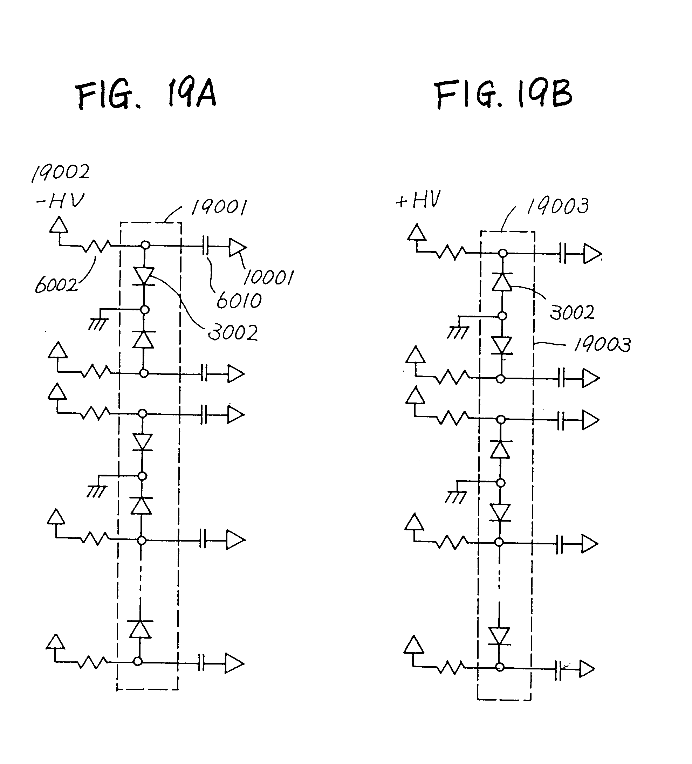

Fig.19A is a circuit figure showing a first example of an electric connection of a detecting device of the fourth embodiment. As shown by the first mounting example of the third embodiment, the passivation layer is deposited on the anode side, and a common electrode is taken by connecting two cathodes in this device 19001. The number of terminals is three per two diodes, which is less than that of the third embodiment. However, the performance of the detecting device 19001 is as good as that of the third embodiment. Fig.19B is a circuit figure showing a second example of an electric connection of the detecting device of the fourth embodiment. The basic idea is similar to the first example of the connection. The passivation layer is deposited on the cathode side, and a common electrode is taken by connecting two anodes in this detecting device 19003. The method of connecting these device, i.e. 19001 and 19003 to PIN electrodes should be considered, based on the methods having been explained in the second and third embodiments. Further, it is convenient that a package for taking electrodes is provided, as shown by Fig.27 of the seventh embodiment.

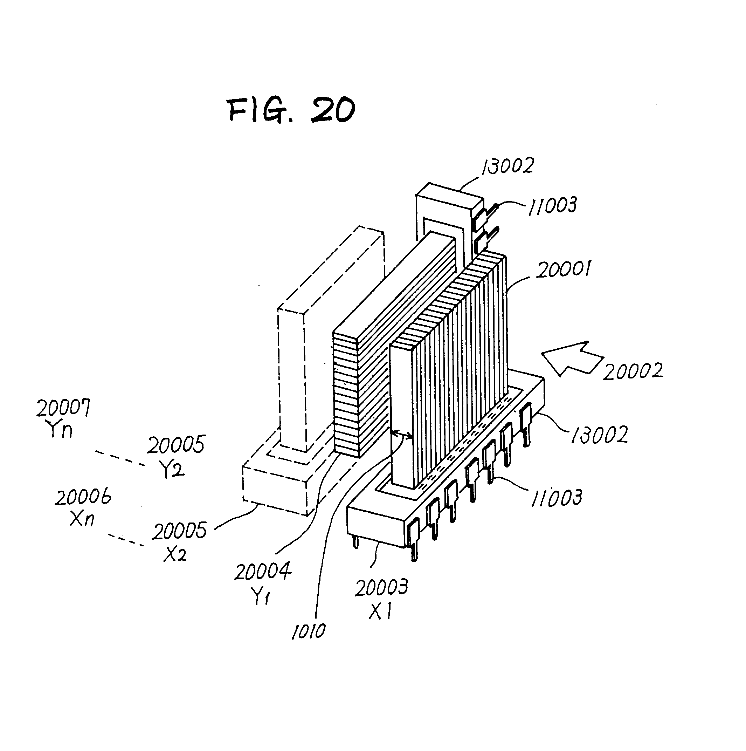

Fig.20 is a perspective view of a detecting device of the fifth embodiment of this invention. Explained so far, A detecting device 20001 mounted in a package is defined as a first detector X,20003, and a 90 degree rotated detector is defined as a second detector Yi2004. The detector Y₁ has the layers vertical to the layers of the first detector X, , that is, the detector Y₁ is positioned at a 90-degree revolution, which makes it possible to have the two-dimensional analysis. An arrow shows an incident direction of X-rays or y-rays. The resolution is heightened by making a thickness of a unit PIN diode decrease from several hundreds of µm to several tens of /1.m. Further, a multilayer-disposition, such as Xᵢ, Yi, X₂, Y₂, ...... Xₙ, Yₙ becomes a convenient way by determining a common side size 1010 of a unit device. The necessary composition for the spectroscopic analysis should be considered case by case.

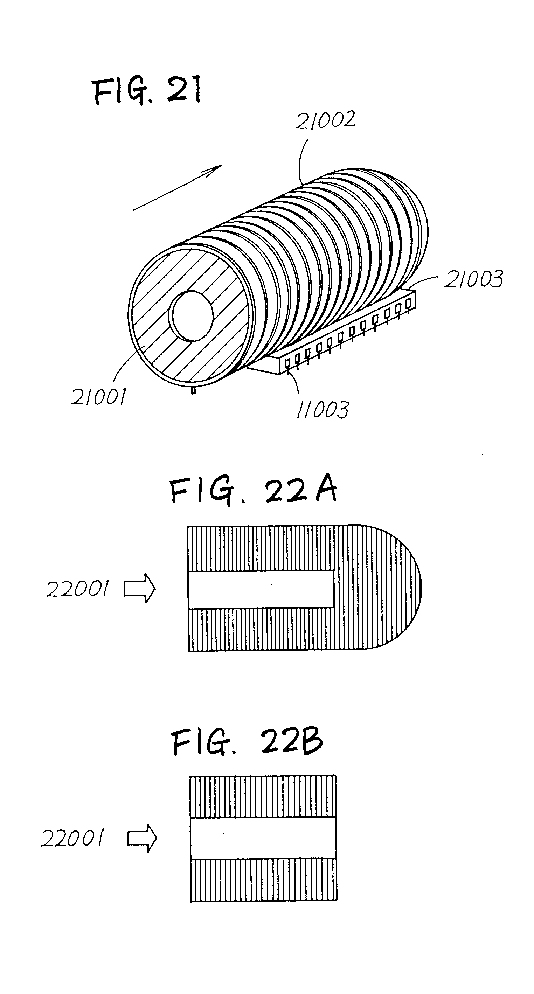

Fig.21 is a perspective view of a detecting device of a sixth embodiment of this invention. A doughnut-type PIN diode can be obtained by changing the shape of a chip, as shown by Fig.21. This detecting device 21002 consists of piled Si-PIN devices 21001 with the center cored, and a package, whereby a detector having the structure similar to the conventional Ge detector can be obtained. It is, however, needless to say that the capacity of this detector for detecting energy and leak current is much higher than prior Ge detectors. Fig.22A is a sectional view of the detecting device of the sixth embodiment of this invention. Fig.22B is a sectional view of the detecting device of a coaxial type of the sixth embodiment of this invention.

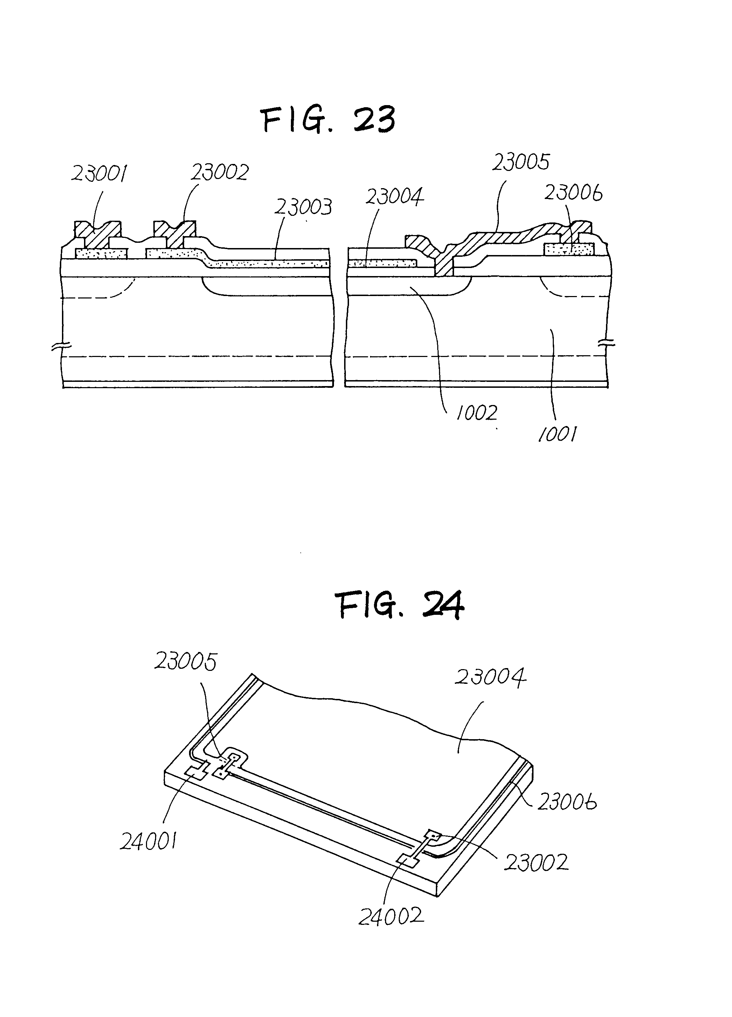

Fig.23 is a sectional view of a PIN diode of a detecting device of a seventh embodiment of this invention. A capacitor insulating layer 23004 which is to be a connection capacitor for reading out is deposited on a P⁺ type layer 1002 as an anode. A polysilicon (polycrystalline Si) layer is deposited on the capacitor insulating layer 23004 which is to be a capacitor electrode 23003. Further, a resistor for bias made from polysilicon is formed on the capacitor insulating layer 23004. Further, in Fig.23, an electrode 23001 for the bias resistor, an electrode 23002 for the capacitor, and an anode 23005 are shown. Fig.24 is a perspective view of a PIN diode of a chip of the detecting device of the seventh embodiment of this invention. A bias resistor pad 24001 and a capacitor electrode pad 24002 are shown therein.

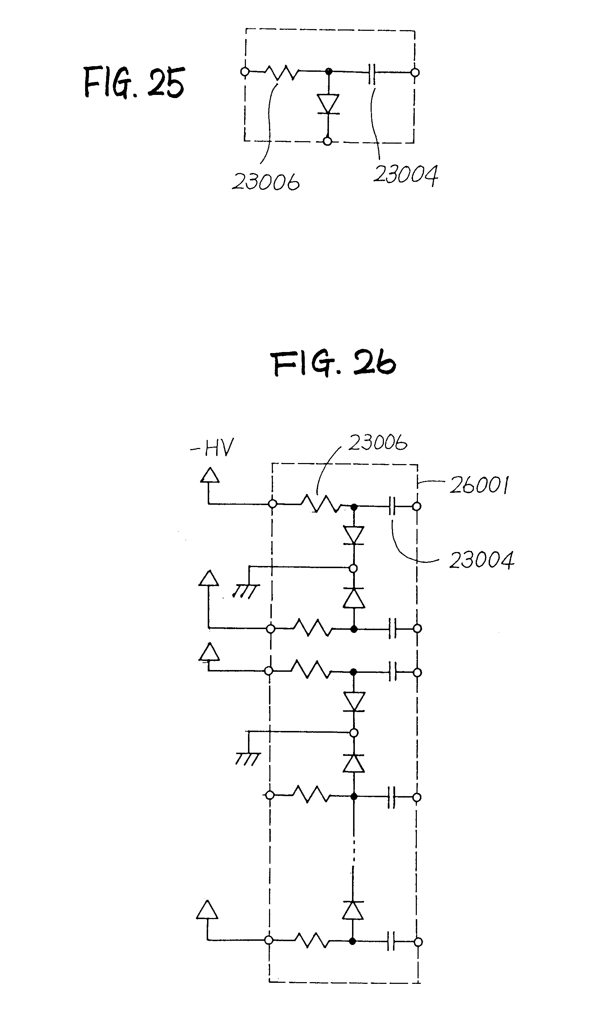

Fig.25 is a circuit figure showing an electric connection of a PIN diode of the detecting device of the seventh embodiment of this invention. A bias resistor 23006 and a capacitor 23004 are built in. Three terminals are set therein. Fig.26 is a circuit figure showing an electric connection of the detecting device of the seventh embodiment, wherein the detecting device 26001 is shown. It is very convenient to simplify the succeeding electric circuits by making the bias resistor and the capacitor built in the device. Further, the space for mounting the circuit can surely be reduced. Fig.27 is a perspective view of the mounted detecting device of the seventh embodiment of this invention. In Fig.27, two armoring cases 27001 and 27002 are placed on the upper side and the down side of the device. As explained in the fifth embodiment, it is very reasonable that the two-dimensional resolution is obtained by positioning second or third detecting devices by arranging in a direction revolving at some degrees.

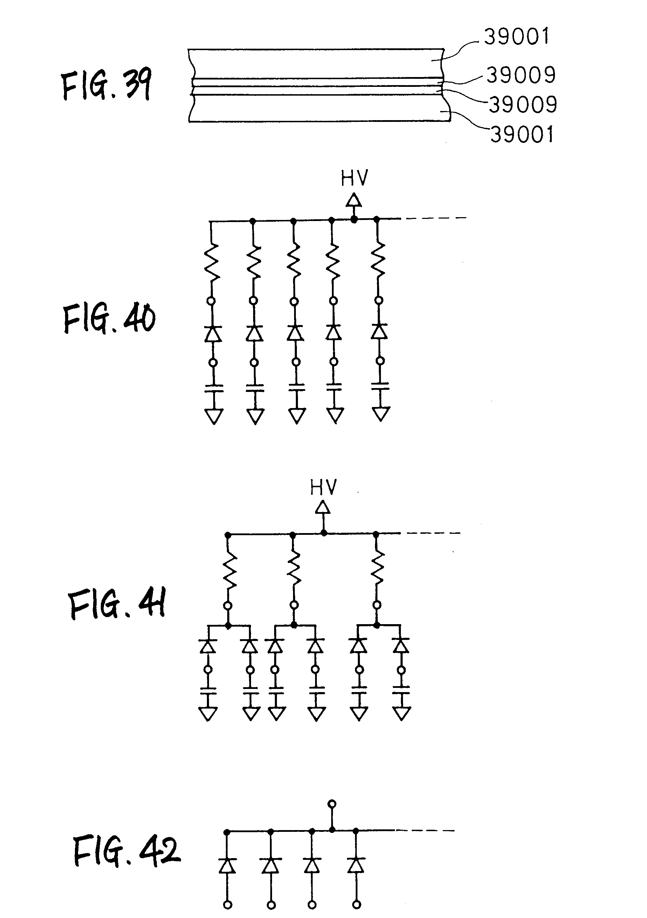

Fig.40 is a circuit figure showing an electric connection of a detecting device of a eighth embodiment of this invention.

Anodes and cathodes of devices are connected in parallel. The cathodes are also connected to a common electrode. The anodes have individual outputs. A line sensor having one-dimensional resolution can be obtained by connecting cathodes with a common electrode for applying a reverse voltage, and by outputting from each anode. In this case, since the reverse voltage is applied in parallel, it is sufficient to apply only a small reverse voltage enough to the form a depletion layer of one unit device.

Fig.41 is a circuit figure showing an electric connection of a detecting device of a ninth embodiment of this invention.

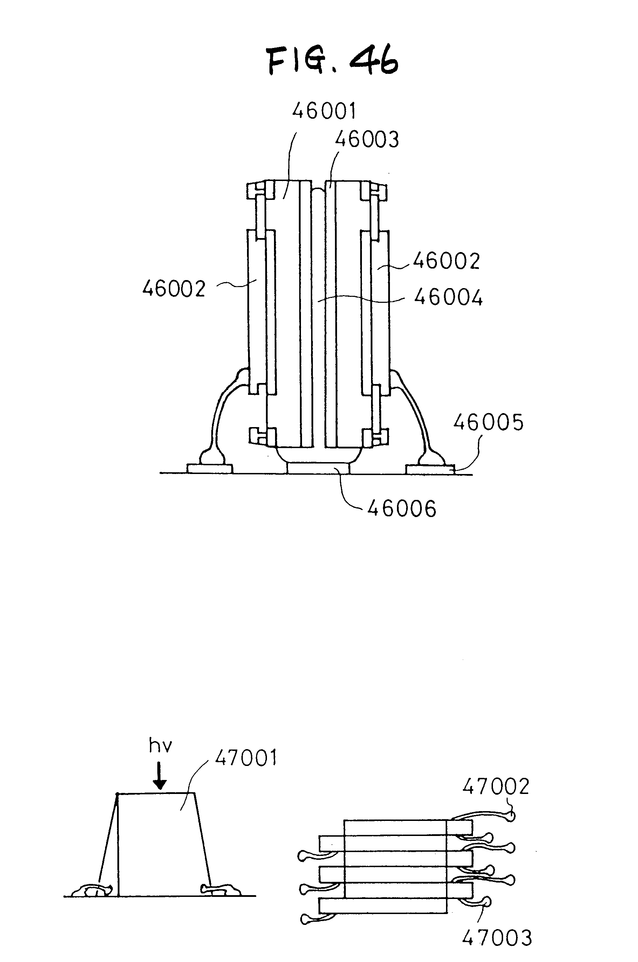

As shown by Fig.46 which is a partial, sectional view of a mounting example of the detecting device of the ninth embodiment, two N- type semiconductor substrates 46001 are faced to each other, wherein the same kind of electrodes are in contact with each other. The pair of the electrodes of the N⁺ type layers 46000 are, for example, connected to the rear surface of the neighboring device with a conductive adhesive 46004. Such pairs of unit devices are heaped by inserting a insulating film therebetween.

In this case, a simple way can be obtained by applying a common reverse voltage to the cathodes of the pairing substrates, and by outputting through each anode.

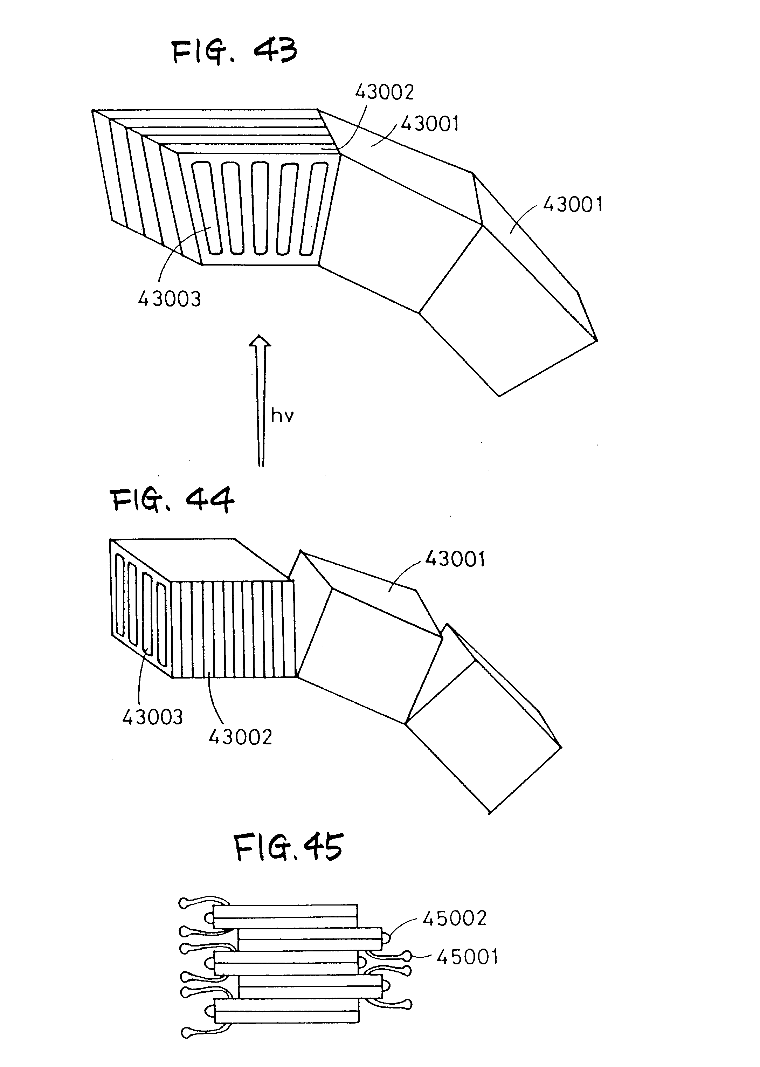

Fig.45 is a plan view showing the above- mounting example. An anode connection part is connected with a conductive adhesive, and a cathode connection part is connected with a wirebon- ding.

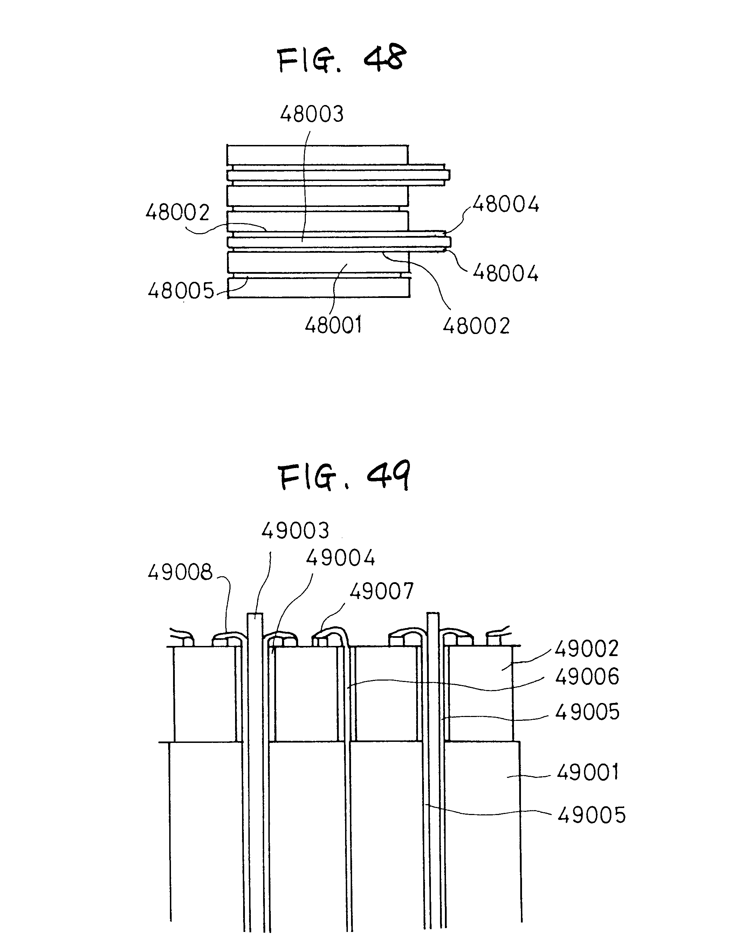

Fig.47A is a side view of another mounting example, and Fig.47B is a plan view of another mounting example. A semiconductor substrate has an incident surface shaped like a trapezoid, and protruded part for mounting easily and for taking electrode terminals on an bottom side.

Fig.48 is a plan view of another mounting example. P⁺ type layers are connected by inserting an insulating film 48003 which has conductive type layers 48004 on both surfaces. Further, pairing cathodes are connected with a conductive adhesive 48005.

Furthermore, another two-dimensional semiconductor device for converting light or radiations into electricity with a high resolution and sensitivity can be obtained by exploiting the large thickness of a depletion layer, a small leak current and a high resolution.

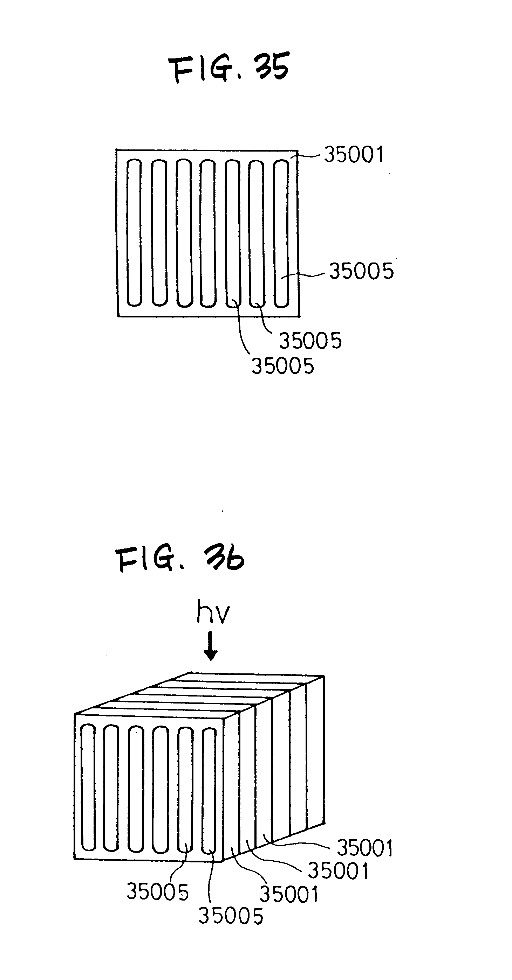

As shown by Fig.35, a P⁺ type layer 35005 formed on the surface of an N- type semiconductor substrate 35001 is divided into a lot of regions shaped like strips. Here, although it is possible to divide a N⁺ type layer formed on the rear surface into pieces, a common N⁺ type layer without dividing into pieces is convenient for the simplicity of electric circuit patterns.

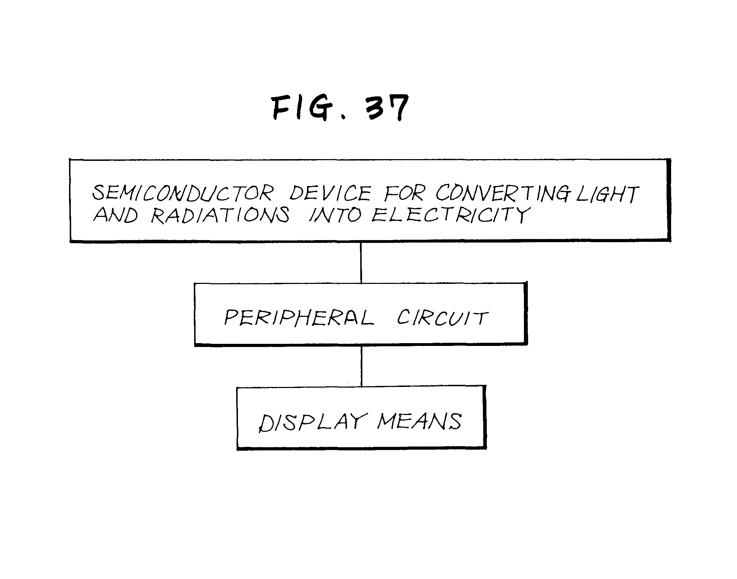

Fig.36 is a perspective view showing a PIN diode. As shown by fig.36, the PIN diode consists of a lot of divided P⁺ type layers which are arranged in the same direction. Further, the diodes are arranged that X-rays or so on are introduced in the direction parallel with the longitudinal direction. A semiconductor device for converting light or radiations into electricity with two-dimensional resolution (which is corresponded to the fourteenth embodiment of this invention) can be obtained thereby. In this case, since the P⁺ type layer is divided by a wafer process, an extremely accurate and minute division is possible. A sensitivity of the device can be enhanced by increasing a thickness of a depletion layer and by decreasing a leak current.

The conventional PIN diode with a scintillator crystal does not satisfy a practical usage, i.e. two-dimensional resolution, even if a P⁺ type layer or an N⁺ type layer of the rear surface is divided into pieces, because of a low sensitivity.

Fig.37 is a diagram of a detector for detecting radiations which is an application of this invention.

In this case, the influence of noise light, in particular the light with a long wavelength, is prevented by forming a film coated with, e.g. Be, C, or Al. by evaporation, and so on, on the incident surface of the device.

The detector for radiations applied by this invention enjoys a wider use in high energy region, a higher speed, and a higher sensitivity than the PIN diode with a scintillator. It is realized to obtain a two-dimensional solid detector for detecting light and radiations by utilizing the semiconductor device of the fourteenth embodiment of this invention.

Further, a good performance can be obtained by utilizing the present device for an X-ray CT device.

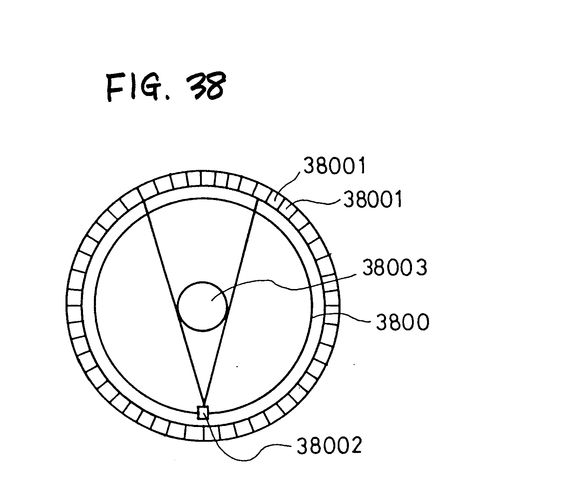

Fig.38 is a conceptional figure for a medical X-ray CT device using the present device.

In this case, a plurality of multi-channel detectors are arranged in a circle in order to response a 360 degree rotation of the X-ray source.

Such an X-ray CT device has benefits, such as a high sensitivity high speed, and so on, whereby the energy of X-rays, radiation time, and radiation quantity are decreased. Therefore, a bad influence caused by radiating X-rays is reduced thereby. Further, it is possible to shorten an operation time, e.g. medical treatments or industrial inspections for detecting X-rays.

In particular, the observation of internal organs' actions and the decrease of X-ray suffering are cited as great advantages of this invention.

Further, an X-ray CT device with a high precision and a high two-dimensional resolution can be obtained by utilizing the fourteenth embodiment of the present device.

In an application of the X-ray CT device, there are two ways to dispose the detector of the present device, considering about the possibility of dividing a P⁺ layer into minute pieces and the difference of surface resolution ability varied by the thickness of a substrate.

The first way will be explained. Fig.43 shows the state of arranging an N- type substrate 43002 in parallel with the multiplied surface in order to compare with the arrangement of the detector 43001 in circle. As shown by Fig.43, the N-type substrate is shaped like a trapezoid, and a P-type layer 43003 is also shaped like a trapezoid. Individual depletion layers can expand in accordance with the spread of a beam of an X-ray fan-shaped beam. This is a great advantage because a good efficiency can be achieved thereby. It is surely possible to obtain a good efficiency by shaping the N- type substrate (and the P⁺ type layer, i.e. the depletion layer) like a trapezoid without dividing the P⁺ type layer.

The second way will be explained. Fig.44 shows the state of arranging an N- type substrate 43002 vertical to the multiplied surface in order to compare with the arrangement of the detector 43001 in circle.

Fig.49 is a partial sectional view of a mounting example of the two-dimensional device in which a P- type layer of a chip is divided into pieces.

Each P- type layer surface is connected with a insulating film both surfaces of which are coated with conductive type layers 49006. The multiplied device connecting each N⁺ type layer surface with conductive films 49006 is fixed to a mounting substrate 49006 installing a through-hole 49004. the conductive layer 49005 is connected to an anode terminal and the conductive film 49006 is connected to a cathode via the through-hole 49006.

It is possible to obtain a high sensitivity, a high accuracy and a high two-dimensional resolution by applying the present device to a detector for detecting X-rays of an X-ray microscope.

In this case, a surface resolution ability is restricted by the ability for dividing the P⁺ type layer into minute pieces, and each semiconductor substrate consisting of multiplied layers. In practice, a strip with a width of several tens of 10 µm and a 200 /1.m thickness of the substrate are minimum limits.

There is the following way for improving these limits.

As shown by Fig.39, each N- type semiconductor substrate 39001 having an N⁺ type layer 39009 on its reverse surface is stuck to each other, wherein each N⁺ type layer 39009 surface is stuck face to face.

Further, a surface resolution in the direction of the thickness of substrate can be improved two times by polishing both surface of the N⁺ type layer before the surfaces are stuck to each other.

As explained till now, this invention can provide a excellent device of converting light and radiations into electricity with the benefits of a high accuracy and a wide detecting area by changing a thickness of a depletion layer, i.e. several millimeter to several tens centimeter (the maximum diameter of a wafer size allowable for an Si wafer process), according to the energy of radiations to be measured. These advantages depend on the structure in which the detecting device consists of planar type PIN diodes deposited, and the thickness of the depletion layer is approximately as same as a side size of the device. Furthermore, excellent devices for detecting radiations are provided by applying this invention.

## Claims

1. A semiconductor device for converting light and radiations into electricity, characterized in that the a plurality of devices consisting of a first conductive semiconductor substrate and a second conductive impurity region formed on the first conductive substrate are piled.

2. A semiconductor device for converting light and radiations into electricity as claimed in claim 1, wherein light or radiations are directly introduced in a direction in parallel with the deposited surfaces of the semiconductor substrate.

3. A semiconductor device for converting light and radiations into electricity as claimed in claim 1, wherein a resistivity of the first conductive semiconductor substrate is more than 1 k^{g} - cm.

4. A semiconductor device for converting light and radiations into electricity as claimed in claim 1, wherein the deposited substrates are connected to each other in parallel.

5. A semiconductor device for converting light and radiations into electricity as claimed in claim 1, wherein each deposited substrate is electrically independent.

6. A semiconductor device for converting light and radiations into electricity as claimed in claim 4, wherein a voltage is applied through a common electrode which is prepared for either an anode or a cathode.

7. A semiconductor device for converting light and radiations into electricity as claimed in claim 1, wherein the same kind of surfaces of the two substrates are faced to each other, and the both electrodes are connected with a conductive adhesive.

8. A semiconductor device for converting light and radiations into electricity as claimed in claim 1, wherein electric terminals are alternatingly formed on opposite side surfaces vertical to an incident direction.

9. A semiconductor device for converting light and radiations into electricity as claimed in claim 7, wherein electric terminal parts are protruded like tags toward an outer direction.

10. A semiconductor device for converting light and radiations into electricity as claimed in claim 1, wherein a resistor component and a capacity component are formed on the same surface of the semiconductor substrate.

11. A semiconductor device for converting light and radiations into electricity, characterized in that a plural device comprising: a first conductive semiconductor substrate and a plurality of semiconductor substrates having a second conductive impurity regions deposited on the first conductive, are neighbored to each other at a certain displacement angle.

12. A semiconductor device for converting light and radiations into electricity as claimed in claim 11, wherein a resistivity of the first conductive semiconductor substrate is more than 1 k^{g} - cm.

13. A semiconductor device for converting light and radiations into electricity as claimed in claim 11, wherein the deposited substrates are connected to each other in parallel.

14. A semiconductor device for converting light and radiations into electricity as claimed in claim 11, wherein a resistor component and a capacity component are formed on the same surface of the semiconductor substrate.

15. A semiconductor device for converting light and radiations into electricity as claimed in claim 1, wherein the second conductive impurity regions are divided into pieces like strips and are formed.

16. A detector for detecting radiations, characterized in that a plurality of the devices consisting of a first conductive semiconductor substrate and a second conductive impurity region formed on the first conductive substrate are piled, and radiations are directly introduced in a direction in parallel with the deposited surfaces of the semiconductor substrate.

17. An X-ray CT device, characterized in that the device consists of a first conductive semiconductor substrate and a plurality of semiconductor substrates having a second conductive impurity regions deposited on the first conductive substrate, and radiations directly enter in a direction in parallel with the deposited surfaces.
